# EUROPÄISCHE PATENTANMELDUNG

(11) **EP 1 429 151 A1**
(43) Veröffentlichungstag der Anmeldung: **16.06.2004**
(21) Anmeldenummer: 03015726.7
(22) Anmeldetag: 10.07.2003
(51) Int. Cl.: G01R 31/36

(54) **Batteriezustandserkennung**

(30) Priorität: 12.12.2002 DE 10258034
(71) Anmelder: ROBERT BOSCH GMBH, 70442 Stuttgart (DE)
(72) Erfinder: Wenger, Christoph, 70825 Korntal-Muenchingen (DE)

(57) **Zusammenfassung**

Es wird eine Batteriezustandserkennung angegeben, die keinen Stromsensor benötigt. Die Batterie ist dabei mit einem Mikroprozessor über eine Schaltungsanordnung verbunden, wobei diese Schaltungsanordnung Mittel zur Spannungsmessung, Mittel zum Spannungsvergleich und gegebenenfalls zur Temperaturmessung sowie Mittel zur Erzeugung eines Ansteuerimpulses umfasst. Dieser Ansteuerimpuls erzeugt einen Spannungsimpuls an der Batterie. Die Impulsantwort wird nach Mittelung bzw. Filterung zur Bestimmung des komplexen Innenwiderstandes der Batterie herangezogen, aus dem dann der Batteriezustand abgeschätzt wird.

## Beschreibung

Die Erfindung betrifft eine Batteriezustandserkennung mit den Merkmalen des Anspruchs 1. Eine solche Batteriezustandserkennung wird insbesondere für Fahrzeugbatterien eingesetzt.

### Stand der Technik

Es ist bekannt, zur Batteriezustandserkennung für Fahrzeugbatterien verschiedenartige Überwachungsmaßnahmen vorzusehen und bestimmte Verfahren zur Batteriezustandserkennung durchzuführen. Ein solches Verfahren sowie eine zugehörige Vorrichtung zur Batteriezustandserkennung ist beispielsweise aus der DE-OS 199 59 016 bekannt. Zur Durchführung dieses Verfahrens zur Batteriezustandserkennung werden Ist-Größen wie die Batteriespannung, der Batteriestrom und die Batterie- oder Umgebungstemperatur gemessen und als Eingangsgrößen für eine Auswerteelektronik verwendet. Diese Elektronik zur Durchführung der bekannten Batteriezustandserkennung, die u.a. wenigstens einen modellbasierten Paramterschätzer und einen Kalman-Filter umfasst, ist in der Lage, aus den gemessenen Ist-Größen die Zustandsgröße der Batterieladung so abzuschätzen, dass diese dem tatsächlichen Wert recht nahe kommen. Die bekannte Batteriezustandserkennung benötigt zwingend einen Stromsensor, der den Batteriestrom misst, ein solcher Stromsensor verursacht jedoch zusätzliche Kosten und kann unter ungünstigen Umständen auch ausfallen und damit eine Batteriezustandserkennung unmöglich machen.

Eine weitere Batteriezustandserkennung, mit deren Hilfe Aussagen über die Leistungsfähigkeit und/oder die Alterung der Batterie, insbesondere einer Fahrzeugbatterie gemacht werden kann, geht davon aus, dass der Batteriezustand auf Basis des Ohm'schen Innenwiderstandes der Batterie abgeschätzt wird. Dazu wird ein definierter Stromimplus auf die Batterie gegeben und ihre Reaktion ausgewertet. Dabei wird jedoch vorausgesetzt, dass die Batterie außer diesem Stromimpuls keine weitere Belastung erfährt, insbesondere dass kein anderer Batteriestrom fließt, dies ist jedoch im normalen Betrieb nicht voraussetzbar.

### Vorteile der Erfindung

Die erfindungsgemäße Batteriezustandserkennung mit den Merkmalen des Anspruchs 1 hat dem gegenüber den Vorteil, dass sie einfach aufgebaut ist und keine Nebenbedingungen hinsichtlich der Batteriebelastung erfüllen muss. Dieser Vorteil wird erhalten, indem eine Batteriezustandserkennung ohne Stromsensorik eingesetzt wird und Maßnahmen getroffen werden, die Auswirkungen der Batteriebelastung bzw. des Batteriestromes auf die eigentliche Batteriezustandserkennung unterbinden. Dazu wird dem durch das Gesamtsystem, also beispielsweise durch das Fahrzeugbordnetz gegebenen Batteriestrom ein bekannter Stromimpuls überlagert und aus der Impulsantwort wird der Zustand der Batterie abgeleitet. Dazu wird aus der Impulsantwort der komplexe Innenwiderstand der Batterie bestimmt, der wesentliche Informationen über den Batteriezustand beinhaltet.

Weitere Vorteile der Erfindung werden durch die in den Unteransprüchen angegebenen Maßnahmen erzielt. So werden durch spezielle Filterungen die Auswirkungen des Gesamtstromes auf das Ergebnis der Batteriezustandserkennung minimiert, insbesondere unter Ausnutzung der Tatsache, dass der Mittelwert des Gesamtstroms ungefähr Null ist. Vorteilhafterweise werden Mittelungen so häufig durchgeführt, dass die Impulsantwort völlig unabhängig vom Fahrzeuggesamtstrom wird.

Besonders vorteilhaft ist also, dass durch eine einfache Stromsenke, eine Spannungsmessung und eine Temperaturmessung der Batteriezustand zuverlässig geschätzt werden kann, obwohl zeitgleich auch Ströme in die Batterie hinein bzw. aus ihr heraus fließen können.

### Zeichnung

Ein Ausführungsbeispiel ist in der Figur dargestellt und wird in der nachfolgenden Beschreibung näher erläutert.

### Beschreibung

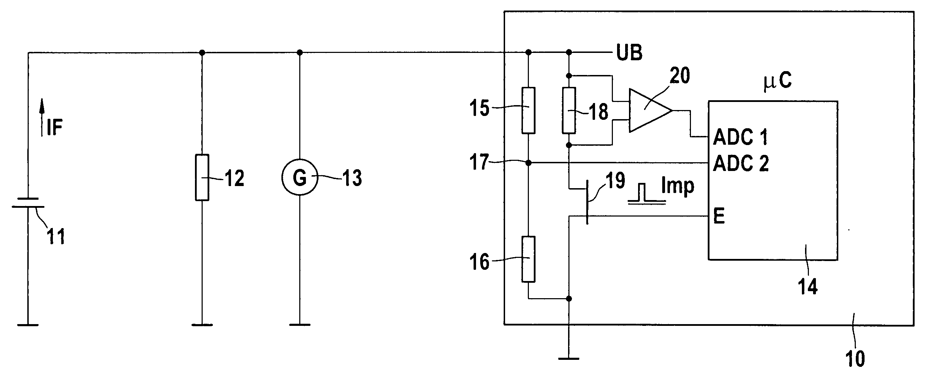

In Figur 1 ist ein Prinzipschaltbild zur Durchführung einer Batteriezustandserkennung für eine Fahrzeugbatterie dargestellt. Diese erfindungsgemäße Batteriezustandserkennung erfolgt in einem Steuergerät zur Batteriezustandserkennung 10 und arbeitet ohne Strommessung.

Im Einzelnen ist in Figur 1 dargestellt:

Eine Batterie 11, insbesondere eine Fahrzeugbatterie, deren Ladezustand ermittelt werden soll, eine Last 12, die beispielsweise die Bordnetzverbraucher des Fahrzeugs symbolisieren soll sowie ein Generator 13, der die elektrische Energie zur Versorgung eines Fahrzeugbordnetzes sowie der zugehörigen Komponenten bereitstellen soll und üblicherweise von einer nicht dargestellten Brennkraftmaschine angetrieben wird. Die Batterie 11, die Last 12 sowie der Generator 13 liegen jeweils parallel zum Steuergerät 10 zwischen Bordnetzspannung UB und Masse. Das Steuergerät 10 umfasst einen Mikroprozessor 14, mit dem Analog-Digital-Convertern ADC 1 und ADC 2 sowie einem weiteren Eingang E. Am Eingang des Steuergerätes 10 liegt die Reihenschaltung zweier Widerstände 15, 16, deren Verbindungspunkt 17 über den ADC 2 mit dem Mikroprozessor 14 in Verbindung steht. Parallel zur Reihenschaltung der Widerstände 15 und 16 liegt ein weiterer Widerstand 18 sowie die Schaltstrecke eines Transistors 19. Beide Reihenschaltungen liegen zwischen Bordnetzspannung UB und Masse. Die beiden Eingänge eines Komparators 20 sind mit der einen, bzw. anderen Seite des Widerstandes 18 verbunden. Der Ausgang des Komparators 20 führt über den Analog-Digital-Converter (Wandler) ADC 1 zum Mikroprozessor. Der Eingang E des Mikroprozessors 14 ist mit der Basis des Transistors 19 verbunden.

Die Funktionsweise der Batterierladezustandserkennung lässt sich wie folgt beschreiben:

Dem durch das Gesamtsystem vorgegebenen Batteriestrom IF wird ein bekannter Stromimpuls Imp überlagert und aus der Impulsantwort wird der Zustand der Batterie abgeleitet. Dabei wird aus der Impulsantwort der komplexe Innenwiederstand der Batterie bestimmt. Der komplexe Innenwiderstand der Batterie enthält wesentliche Informationen über den Batteriezustand, die im Mikroprozessor 14 des Steuergerätes 10 ausgewertet werden. Da die Implusantwort, die im Mikroprozessor 14 ausgewertet wird, auch vom Gesamtbatteriestrom IF beeinflusst wird, ist es notwendig, eine entsprechende Filterung vorzusehen. Dabei wird ausgenützt, dass der Mittelwert des Gesamtstromes IF ungefähr Null ist. Bei einer entsprechend häufigen Mittelung ergibt sich demnach die Impulsantwort unabhängig vom gesamten Batteriestrom IF.

Das Auswerteprinzip der in Figur 1 dargestellten Batteriezustandserkennung ohne Strommessung besteht darin, dass durch eine einfache definierte Stromsenke, eine Spannungsmessung und eine Temperaturmessung der Batteriezustand geschätzt werden kann, obwohl zusätzliche Ströme in die Batterie hinein bzw. aus der Batterie heraus fließen. Die Spannungsmessung erfolgt dabei im Steuergerät selbst. Die Temperaturmessung kann mittels eigenem Sensor erfolgen oder wird im Steuergerät durchgeführt oder es liegt die Temperatur im Steuergerät ohnehin vor.

Eine mögliche Ausführungsform besteht darin, den Stromimpuls Imp durch einen Transistor 19 als Schalter und einen zugehörigen Widerstand zu generieren. Dabei wird der Transistor durch den Mikroprozessor 14 in geeigneter Weise angesteuert. Die Spannung an dem Widerstand und die Batteriespannung werden über den Mikroprozessor bzw. Mikrokontroller abgetastet, zwischengespeichert und miteinander verrechnet. Die Spannungsmessung selbst erfolgt im Steuergerät 10. Dabei misst der Kanal bzw. Analog-Digital-Wandler ADC 1 die Spannung am Belastungswiderstand und damit den Strom. Der Kanal bzw. Analog-Digital-Wandler ADC2 misst die Batteriespannung. Für einen geeigneten Stromimpuls Imp sind nominal 5 Ampere und eine Ansteuerdauer von 20 ms vorgesehen.

Um beispielsweise die Einflüsse des Bordnetzes zu eliminieren bzw. um die Auswirkungen der stets fließenden Ströme zu verringern wird die Impulsantwort über mehrere Stromimpulse gemittelt. Es werden dazu also vom Steuergerät 10 mehrere Ansteuersignale zu vorgebbaren Zeiten für den Transistor 19 generiert. Die Auswertung der sich ergebenden Impulsantwort bzw. Impulsantworten erfolgte im Mikroprozessor 14, der prinzipiell auch in der Lage ist, die erforderlichen Filterungen und Mittelwertbildungen durchzuführen und dazu geeignete Mittel aufweist.

Die Batteriezustandserkennung wird üblicherweise in einem eigenen Bordnetzsteuergerät durchgeführt, kann aber auch im Motorsteuergerät durchgeführt werden, wobei vorausgesetzt wird, dass die benötigten Informationen über geeignete Verbindungen ausgetauscht werden.

## Patentansprüche

1. Batteriezustandserkennung für eine Batterie, die mit einem Mikroprozessor in Verbindung steht, wobei zwischen dem Mikroprozessor und der Batterie eine Schaltungsanordnung angeordnet ist, **dadurch gekennzeichnet, dass** die Schaltungsanordnung wenigstens Mittel zur Spannungserfassung, Mittel zum Spannungsvergleich sowie Mittel zur Erzeugung eines Ansteuerimpluses umfasst und diese Mittel über entsprechende Anschlüsse mit dem Mikroprozessor in Verbindung stehen.

2. Batteriezustandserkennung nach Anspruch 1, **dadurch gekennzeichnet, dass** die Batterie eine Fahrzeugbatterie ist und der Mikroprozessor Bestandteil eines Steuergerätes ist.

3. Batteriezustandserkennung nach Anspruch 1, 2 oder 3, **dadurch gekennzeichnet, dass** das Steuergerät ein Bordnetzsteuergerät oder das Motorsteuergerät ist.

4. Batteriezustandserkennung nach Anspruch 1, 2, 3 oder 4, **dadurch gekennzeichnet, dass** verschiedene gemessene Spannungen miteinander verglichen werden und das Vergleichsergebnis dem Mikroprozessor zugeführt wird.

5. Batteriezustandserkennung nach einem der vorhergehenden Ansprüche, **dadurch gekennzeichnet, dass** die Schaltungsanordnung einen Transistor umfasst, dessen Basis vom Mikroprozessor zur Impulserzeugung angesteuert wird.

6. Batteriezustandserkennung nach Anspruch 5, **dadurch gekennzeichnet, dass** zu vorgebbaren Zeiten oder bei vorgebbaren Bedingungen ein oder mehrere Stromimpulse erzeugt werden, die der Batterie zugeführt werden und die sich einstellende Spannungsveränderung ermittelt wird.

7. Batteriezustandserkennung nach einem der vorhergehenden Ansprüche, **dadurch gekennzeichnet, dass** der komplexe Innenwiderstand der Batterie ausgehend von einer gemessenen Spannung und einer gemessenen Temperatur, die beide vom Batteriezustand abhängig sind, ermittelt wird und daraus der Batteriezustand geschätzt wird.

8. Batteriezustandserkennung nach einem der vorhergehenden Ansprüche, **dadurch gekennzeichnet, dass** die auszuwertende Spannung gemittelt oder gefiltert wird, wobei dazu wenigstens zwei Spannungswerte berücksichtigt werden, die sich jeweils nach Zuführung eines Impulses zur Batterie ergeben.

9. Batteriezustandserkennung nach einem der vorhergehenden Ansprüche, **dadurch gekennzeichnet , dass** die Mittel zur Filterung oder zur Mittelwertbildung Bestandteil des Steuergerätes, insbesondere des Mikroprozessors sind.
